# EUROPÄISCHE PATENTSCHRIFT

(11) **EP 3 385 733 B1**
(45) Veröffentlichungstag und Bekanntmachung des Hinweises auf die Patenterteilung: **28.08.2019**
(21) Anmeldenummer: 18162703.5
(22) Anmeldetag: 20.03.2018
(51) Int. Cl.: G01R 31/02, G01R 31/08, G01R 31/40, H02J 1/10

(54) **ISOLATIONSFEHLERSUCHSYSTEME UND VERFAHREN ZUR ISOLATIONSFEHLERSUCHE FÜR EIN REDUNDANTES DIODEN-GEKOPPELTES GLEICHSTROM-STROMVERSORGUNGSSYSTEM**
ISOLATION ERROR TROUBLESHOOTING SYSTEMS AND METHODS FOR ISOLATION ERROR TROUBLESHOOTING FOR A REDUNDANT DIODE-COUPLED DIRECT CURRENT SUPPLYING SYSTEM
SYSTÈMES DE DÉTECTION D'ERREURS D'ISOLATION ET PROCÉDÉS DE DÉTECTION D'ERREURS D'ISOLATION POUR UN SYSTÈME D'ALIMENTATION EN COURANT CONTINU REDONDANT COUPLÉ AUX DIODES

(30) Priorität: 06.04.2017 DE 102017205931
(43) Veröffentlichungstag der Anmeldung: 10.10.2018
(73) Patentinhaber: Bender GmbH & Co. KG, 35305 Grünberg (DE)
(72) Erfinder: HACKL, Dipl.-Ing. Dieter, 35463 Fernwald (DE); HARTMANN, Carsten, 63679 Schotten (DE)
(74) Vertreter: advotec.

(56) Entgegenhaltungen:
- EP-A1- 2 793 339
- EP-A1- 2 813 856
- US-A- 5 075 628
- W Encelin: "EDS3090", , 31. Januar 2009 (2009-01-31), Seiten 1-64, XP055499621, Gefunden im Internet: URL:https://www.bender.de/fileadmin/conten t/Products/m/fr/EDS3090-v1-0_TGH_fr.pdf [gefunden am 2018-08-14]

## Beschreibung

Die Erfindung betrifft Isolationsfehlersuchsysteme und Verfahren zur Isolationsfehlersuche gemäß dem jeweiligen in den Vorrichtungsansprüchen 1, 2, 4, 5, 6 und 7 sowie den Verfahrensansprüchen 8, 9, 11, 12, 13 und 14 wiedergegebenen Oberbegriff für ein ungeerdetes Gleichstrom-Stromversorgungssystem, welches redundant aus einer ersten Dioden-gekoppelten Gleichspannungs-Versorgungsquelle und einer zweiten Dioden-gekoppelten Gleichspannungs-Versorgungsquelle gespeist ist und an das ein Verbraucher redundant über eine erste aus zwei aktiven Leitern bestehende Zuleitung und eine zweite aus zwei aktiven Leitern bestehende Zuleitung angeschlossen ist.

Für die Versorgung von elektrischen Betriebsmitteln kommt bei erhöhten Anforderungen an die Betriebs-, Brand und Berührungssicherheit die Netzform eines ungeerdeten Stromversorgungssystems zum Einsatz, die auch als isoliertes Netz (frz. Isolé Terre - IT) oder als IT-Stromversorgungssystem bezeichnet wird. Bei dieser Art des Stromversorgungssystems sind die aktiven Teile von dem Erdpotenzial - gegenüber "Erde" - getrennt. Der Vorteil dieser Netze liegt darin, dass bei einem ersten Isolationsfehler wie beispielsweise einem Erdschluss oder einem Körperschluss die Funktion der elektrischen Betriebsmittel nicht beeinträchtigt wird, da sich wegen des im Idealfall unendlich großen Impedanzwertes zwischen den aktiven Leitern des Netzes und Erde in diesem ersten Fehlerfall (erster Fehler) kein geschlossener Stromkreis ausbilden kann.

Durch die inhärente Sicherheit des ungeerdeten Stromversorgungssystems kann somit eine kontinuierliche Stromversorgung der an das ungeerdete Stromversorgungssystem angeschlossenen Verbraucher auch dann gewährleistet werden, wenn ein erster Isolationsfehler auftritt.

Der elektrische Widerstand des ungeerdeten Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Unter der Voraussetzung, dass der Isolationszustand des ungeerdeten Stromversorgungssystems kontinuierlich von einem Isolationsüberwachungsgerät überwacht wird, kann das ungeerdete Stromversorgungssystem auch bei einem aufgetretenen ersten Fehler ohne vorgeschriebene Zeitlimitierung weiterbetrieben werden, jedoch gilt gemäß den Normen DIN VDE 0100-410 bzw. IEC 60364-4-41 die Empfehlung, den ersten Fehler so schnell wie praktisch möglich zu beseitigen.

Um die Anforderung nach einer schnellen Beseitigung des ersten Fehlers zu erfüllen, stellt insbesondere in ausgedehnten, komplexen ungeerdeten Stromversorgungssystemen oder in ungeerdeten Stromversorgungssystemen, in denen eine Abschaltung der Energieversorgung für das komplette ungeerdete Stromversorgungssystem sicherheitskritisch sein kann, der Einsatz eines Isolationsfehlersuchsystems den Stand der Technik dar, welches in der Regel einen Prüfstromgenerator und ein Isolationsfehlersuchgerät (Auswertegerät) mit daran angeschlossenen Messstromwandlern umfasst.

Ist in dem ungeerdeten Stromversorgungssystem ein erster Isolationsfehler von dem Isolationsüberwachungsgerät erkannt worden, startet die Isolationsfehlersuche, indem der Prüfstromgenerator - der als separates Gerät oder auch als Bestandteil des Isolationsüberwachungsgerätes ausgeführt sein kann - einen Prüfstrom erzeugt und diesen an zentraler Stelle in das ungeerdete Stromversorgungssystem einspeist. Es entsteht ein geschlossener Stromkreis, in dem der Prüfstrom oder ein Prüfstromanteil von dem Prüfstromgenerator über die spannungsführenden aktiven Leiter, den Isolationsfehler und über eine Erdverbindung zurück zu dem Prüfstromgenerator fließt.

Zur Lokalisierung des Fehlerortes in dem ungeerdeten Stromversorgungssystem dient das Isolationsfehlersuchgerät mit den daran angeschlossenen Messstromwandlern, wobei jedem zu überwachenden Leitungszweig ein Messstromwandler fest zugeordnet ist.

Der Prüfstrom oder der Prüfstromanteil wird von allen Messstromwandlern, die in dem Prüfstromkreis (Fehlerstromkreis) liegen, erfasst und durch das Isolationsfehlersuchgerät ausgewertet und angezeigt. Durch die bekannte Zuordnung der Messstromwandler zu den Leitungszweigen kann der Fehlerort lokalisiert werden.

In sicherheitskritischen oder für die Versorgungssicherheit bedeutsamen Anlagen, wie beispielsweise bei Bahnanlagen, Kraftwerken oder Umspannwerken bestehen erhöhte Anforderungen an einen unterbrechungsfreien Betrieb.

Erfüllt werden diese Anforderungen durch redundant ausgelegte Stromversorgungssysteme. In ungeerdeten Gleichstrom-Stromversorgungssystemen werden daher sicherheitskritische Verbraucher oftmals Dioden-gekoppelt über zwei getrennte Zuleitungen (Leitungszweige) von zwei Gleichspannungs-Versorgungsquellen redundant versorgt.

Allerdings kann die Topologie des zweifach ausgelegten, Dioden-gekoppelten Gleichstrom-Stromversorgungssystems zu Störungen bei der Fehlerlokalisierung führen.

Auf Grund der Diodenkopplung entstehen sich nicht kompensierende Teilströme in den Zuleitungen (unsymmetrische Stromteilung des Laststroms) und somit von dem jeweiligen Messstromwandler erfassbare Differenzstromanteile, die einen gültigen Prüfstrom stören können.

Geringste Schwankungen einer der beiden Versorgungsspannungen können zu einer Modulation der Arbeitspunkte der nichtlinearen Diodenkennlinien und damit zu einer wechselseitigen Durchlassspannungs-Schwankung an den beiden Dioden führen. Insbesondere niederfrequente, geringe Schwankungen der Versorgungsspannung in einem Frequenzbereich, der von dem Isolationsfehlersuchsystem für die Erzeugung eines Prüfstroms bevorzugt genutzt wird - beispielsweise Spannungsschwankungen mit einer Amplitude von 50 mV bei einer Frequenz von 1 Hz -, können einen Stromfluss zur Folge haben, der in Frequenzlage und Amplitude näherungsweise dem üblicherweise von dem Isolationsfehlersuchsystem verwendeten Prüfsignal entspricht.

Auch unterschiedliche Diodenkennlinien können einen Gleichstrom-Differenzstrom selbst bei sonst symmetrischen Verhältnissen zur Folge haben.

Eine fehlerhafte Detektion des Prüfstroms und somit eine Störung der Isolationsfehlersuche erscheinen daher sehr wahrscheinlich.

Sind die Versorgungsspannungen der redundanten Gleichspannungs-Versorgungsquellen unterschiedlich, so kann es, vor allem in Abhängigkeit von der Amplitude der Gleichspannungen und dem Wert des Lastwiderstands des Verbrauchers, auch zu einem relativ großen Gleichstrom-Differenzstrom kommen.

Ein großer Gleichstrom-Differenzstrom wiederum kann, bei Verwendung von marktüblichen Messstromwandlern, durch Sättigungseffekte im Kernmaterial des Messstromwandlers, zu einer verschlechterten Selektivität bei der Fehlerlokalisierung, d.h. zu einer erschwerten Bestimmung des Fehlers in untergeordneten Versorgungszweigen, und bis zum Ausfall der Fehlerlokalisierungsfunktion führen.

Aus dem Stand der Technik sind zur Lösung der dargelegten Probleme vornehmlich drei unterschiedliche Ansätze bekannt:
a) Einsatz der sogenannten Holmgreen-Schaltung. Diese entspricht einer Parallelschaltung der Sekundärseite von mehreren Messstromwandlern. Erfolgreich wird diese Schaltung zur Gewinnung des Summenstroms in reinen AC-Systemen (50 Hz, 60 Hz) eingesetzt. Voraussetzung für eine zufriedenstellende Funktion ist allerdings eine gute Übereinstimmung der Übertragungseigenschaften der verschalteten Messstromwandler.
   Bei Systemen mit niederfrequenten Signalanteilen und DC-Komponenten funktioniert das Verfahren bei Standard-Messstromwandlern (Messstromwandlern vom Typ A) nur sehr bedingt, da diese Signalkomponenten von den Standard-Messstromwandlern nicht oder nur unzureichend erfasst werden.
b) Einseitige Erhöhung der Versorgungsspannung bei einer der beiden DC Spannungsquellen.
   Dieser Ansatz hat allerdings einen relativ großen Gleichstrom-Differenzstrom zur Folge, der in nachteiliger Weise zu dem oben beschriebenen Sättigungseffekt im Kernmaterial des Magnetkreises des Messstromwandlers führen kann.
c) Ein zeitweises, wechselseitiges Aufheben der Doppelspeisung einzelner Verbraucher während der Fehlerlokalisierung. Dieser Lösungsansatz verlangt einen manuellen Eingriff von versierten Fachleuten und beinhaltet das Risiko, dass vergessen wird, nach vollendeter Fehlerlokalisierung die Doppelspeisung der Verbraucher wieder korrekt einzurichten. Eine Auftrennung der Verbindung zwischen den Minuspolen der beiden redundanten Gleichspannungs-Versorgungsquellen würde zwar helfen, ist jedoch in den meisten Anlagen nicht zulässig, da bestimmte zu betrachtende Fehlersituationen dazu führen können, dass die redundanten Gleichspannungs-Versorgungsquellen in Reihe geschaltet werden und infolge der dadurch auftretenden verketteten Spannung Probleme mit der Isolationskoordination der Anlage entstehen können.

Eine vollautomatische Fehlerlokalisierung ist somit auf diese Weise in den meisten Anwendungsfällen nicht realisierbar.

Ein weiteres Beispiel für den Stand der Technik kann dem Dokument XP055499621 mit dem Titel EDS3090 entnommen werden.

Der vorliegenden Erfindung liegt somit die Aufgabe zu Grunde, die Fehlerlokalisierung in ungeerdeten, Dioden-gekoppelten Gleichstrom-Stromversorgungssystemen technisch zu vereinfachen und dabei zuverlässig sowie wirtschaftlich kostengünstig zu gestalten. Isolationsfehlersuchsystem A: Diese Aufgabe wird mit einem Isolationsfehlersuchsystem A gemäß Anspruch 1 erfindungsgemäß dadurch gelöst, dass zwischen den aktiven Leitern der ersten Zuleitung ein erster Widerstandspfad und zwischen den aktiven Leitern der zweiten Zuleitung ein zweiter Widerstandspfad angeordnet ist, deren jeweiliger elektrischer Widerstand so dimensioniert ist, dass ein Kompensationsstrom in dem jeweiligen Widerstandspfad fließt, der gleich einem durch die Erhöhung der Versorgungsspannung bewirkten störenden Gleichstrom-Differenzstrom in der betreffenden Zuleitung ist und der von dem jeweiligen Messstromwandler in entgegengesetzter Richtung des Gleichstrom-Differenzstroms primärseitig erfasst wird.

Der Grundgedanke dieser Lösung besteht darin, zunächst mittels einer an einer der beiden Gleichspannungs-Versorgungsquellen angeordneten Einstelleinrichtung eine aus dem Stand der Technik bekannte einseitige Erhöhung einer der beiden Versorgungsspannungen vorzunehmen und dann den durch die einseitige Erhöhung hervorgerufenen störenden Gleichstrom-Differenzstrom soweit abzuschwächen, dass die Erkennung des Prüfstroms oder des Prüfstromanteils zuverlässig möglich ist, die Fehlerlokalisierung somit nicht negativ beeinflusst wird. Durch die Erzeugung eines Kompensationsstroms wird in dem jeweiligen Messstromwandler primärseitig der Gleichstrom-Differenzstrom weitgehend kompensiert, um Sättigungseffekte in dem Kernmaterial des Messstromwandlers zu vermeiden. Dazu ist jeweils ein passiver Widerstandspfad zwischen den aktiven Leitern der ersten Zuleitung und zwischen den aktiven Leitern der zweiten Zuleitung in der Weise installiert, dass der Kompensationsstrom den jeweiligen Messstromwandler in entgegengesetzter Richtung des störenden Gleichstrom-Differenzstroms durchfließt und somit seine kompensatorische Wirkung entfaltet. Der betreffende Widerstandspfad weist einen konstanten elektrischen Widerstand mit einem Wert auf, der so bemessen ist, dass der von einer zwischen den aktiven Leitern herrschenden Potentialdifferenz (Spannung) getriebene Kompensationsstrom einen Betrag aufweist, der dem des störenden Gleichstrom-Differenzstroms entspricht.

Es genügt, wenn die Kompensation nur so weit gelingt, dass die Beeinflussung des Messstromwandler-Magnetkreises unterhalb einer Schwelle bleibt, bis zu der das Isolationsfehlersuchsystem A spezifikationsgemäß fehlerfrei arbeitet.

Durch die erfindungsgemäße Anordnung des Widerstandspfades kann auf die sekundärseitige Parallelschaltung der Messstromwandler verzichtet werden. Da infolge einer weitgehend fehlerfreien Detektion des Prüfstroms die Selektivität bei der Bestimmung des Fehlerortes erhöht wird, kann der fehlerhafte Versorgungszweig zuverlässig lokalisiert werden. Isolationsfehlersuchsystem B: Die Aufgabe wird weiterhin mit einem Isolationsfehlersuchsystem B gemäß Anspruch 2 erfindungsgemäß dadurch gelöst, dass zwischen den aktiven Leitern der ersten Zuleitung und zwischen den aktiven Leitern der zweiten Zuleitung jeweils ein Strompfad mit einer Stromeinstelleinrichtung angeordnet ist, die laststromabhängig einen Kompensationsstrom einstellt, der gleich einem durch die Erhöhung der Versorgungsspannung bewirkten störenden Gleichstrom-Differenzstrom in der betreffenden Zuleitung ist und der von dem jeweiligen Messstromwandler in entgegengesetzter Richtung des Gleichstrom-Differenzstroms primärseitig erfasst wird.

Auch bei dieser Lösung beruht der Grundgedanke darauf, nach einer einseitigen Erhöhung einer der beiden Versorgungsspannungen den dadurch hervorgerufenen störenden Gleichstrom-Differenzstrom in dem Messstromwandler primärseitig durch einen Kompensationsstrom auszugleichen.

Allerdings kann bei relativ großen Schwankungen des Lastwiderstands die primärseitige Kompensation des Gleichstrom-Differenzstromes durch einen passiven Widerstandspfad mit einem konstantem elektrischen Widerstand nicht ausreichen, um die Beeinflussung des Messstromwandler-Magnetkreises gering genug zu halten und somit eine Fehlerlokalisierung, wie sie in den technischen Daten des verwendeten Isolationsfehlersuchsystems spezifiziert ist, zu ermöglichen.

Daher ist statt eines passiven Widerstandspfads zwischen den aktiven Leitern der ersten Zuleitung und zwischen den aktiven Leitern der zweiten Zuleitung jeweils ein Strompfad mit einer Stromeinstelleinrichtung angeordnet, die laststromabhängig einen Kompensationsstrom einstellt, dessen Betrag gleich einem durch die Erhöhung der Versorgungsspannung bewirkten störenden Gleichstrom-Differenzstrom in der betreffenden Zuleitung ist und der diesem störenden Gleichstrom-Differenzstrom entgegengerichtet ist.

Ausgehend davon, dass eine Reduzierung des Lastwiderstandes zu einer umgekehrt proportionalen Steigerung des Laststroms führt, kann diese Laststromänderung wiederum zu einer proportionalen Steigerung des Kompensationsstroms genutzt werden. Die Kompensationsqualität wird damit so weit verbessert, dass eine Beeinflussung des Messstromwandler-Magnetkreises unterhalb der Schwelle bleibt, die eine Fehlerlokalisierung, wie sie in den technischen Daten des verwendeten Isolationsfehlersuchsystems spezifiziert ist, ermöglicht.

Die Anforderungen an die Gleichstrom-Laststrommessung sind hierbei nicht allzu hoch. In den meisten Anwendungsfällen können kostengünstige Halbleitersensoren oder vergleichbar günstige Gleichstrom-Sensoren eingesetzt werden.

Ziel der erfindungsgemäßen laststromabhängigen Einstellung, die als Steuerung oder Regelung ausgeführt sein kann, ist es, die spezifizierten Toleranzgrenzen der zum Einsatz kommenden Messstromwandler einzuhalten und nicht eine vollständige Kompensation im Bereich der Messgenauigkeit des verwendeten Isolationsfehlersuchsystems durchzuführen, wie z.B. bei Kompensationsstromwandlern.

In weiterer vorteilhafter Ausgestaltung weist die Stromeinstelleinrichtung eine einstellbare Stromquelle zur Erzeugung des Kompensationsstroms und einen Stromsensor zur Gleichstrom-Laststrommessung auf.

Der Gleichstrom-Laststrom wird mit einem Stromsensor in einer der beiden aktiven Leiter der jeweiligen Zuleitung erfasst, wobei das Messsignal des Stromsensors zur Laststrom-proportionalen Steuerung der einstellbaren Stromquelle herangezogen wird. Der Stromsensor kann als Halbleiter-Sensor oder als vergleichbar kostengünstiger Gleichstrom-Sensor ausgeführt sein.

Mit den oben beschriebenen erfindungsgemäßen Isolationsfehlersuchsystemen A und B wird in Verbindung mit kostengünstigen Standard-Messstromwandlern (Messstromwandler vom Typ A) eine hohe Empfindlichkeit bei der Detektion des Prüfstroms und damit eine zuverlässige Fehlerortung erreicht.

Isolationsfehlersuchsystem C.1: Die Aufgabe wird weiterhin mit einem Isolationsfehlersuchsystem C.1 gemäß Anspruch 4 erfindungsgemäß dadurch gelöst, dass der erste und der zweite Messstromwandler als allstromsensitive Messstromwandler (Messstromwandler vom Typ B) mit Stromausgang ausgeführt sind und sekundärseitig parallel geschaltet sind zur mittelbaren Kompensation von Differenzstromanteilen.

Im Gegensatz zu den beiden zuvor beschriebenen Isolationsfehlersuchsystemen A und B bleibt bei dem Isolationsfehlersuchsystem C.1 eine Einstelleinrichtung zur Erhöhung einer Versorgungsspannung - falls vorhanden - unberücksichtigt, es erfolgt somit bei dieser Lösung keine einseitige Erhöhung einer der beiden Versorgungsspannungen. Stattdessen werden allstromsensitive Messstromwandler (Messstromwandler vom Typ B) zur Erfassung der in den Zuleitungen fließenden Differenzstromanteile eingesetzt und eine schaltungstechnische Subtraktion der von den beiden Messstromwandlern bereitgestellten Messsignale vorgenommen.

In dem Isolationsfehlersuchsystem C.1 kommen Messstromwandler vom Typ B mit Stromausgang zum Einsatz, die sekundärseitig parallel geschaltet sind. Mit der Parallelschaltung werden die von den Messstromwandlern gelieferten Messsignale (Messströme) schaltungstechnisch subtrahiert und damit primärseitig erfasste, entgegengerichtete Differenzströme, insbesondere neben den reinen Wechselstrom-Differenzströmen - als Vorteil gegenüber der bekannten Holmgreen-Schaltung - auch Gleichstrom- und niederfrequente Differenzstromanteile, mittelbar kompensiert.

Isolationsfehlersuchsystem C.2: Die Aufgabe wird weiterhin mit einem Isolationsfehlersuchsystem C.2 gemäß Anspruch 5 erfindungsgemäß dadurch gelöst, dass der erste und der zweite Messstromwandler als allstromsensitive Messstromwandler (Messstromwandler vom Typ B) mit Spannungsausgang ausgeführt sind und sekundärseitig in Reihe geschaltet sind zur mittelbaren Kompensation von Differenzstromanteilen.

Wie bei der zuvor dargestellten Alternativlösung (Isolationsfehlersuchsystem C.1) ist auch bei dem Isolationsfehlersuchsystem C.2 eine Einstelleinrichtung zur Erhöhung einer Versorgungsspannung nicht erforderlich und es kommen ebenso allstromsensitive Messstromwandler (Messstromwandler vom Typ B) zum Einsatz. Jedoch sind die Messstromwandler in dem Isolationsfehlersuchsystem C.2 als Typ B Messstromwandler mit Spannungsausgang ausgeführt, deren Ausgänge sekundärseitig in Reihe geschaltet sind.

Mit der Reihenschaltung werden die von den Messstromwandlern gelieferten Messsignale (Messspannungen) schaltungstechnisch subtrahiert und damit primärseitig erfasste, entgegengerichtete Differenzströme, insbesondere neben den reinen Wechselstrom-Differenzströmen auch Gleichstrom- und niederfrequente Differenzstromanteile, mittelbar kompensiert.

Isolationsfehlersuchsystem C.3: Die Aufgabe wird weiterhin mit einem Isolationsfehlersuchsystem C.3 gemäß Anspruch 6 erfindungsgemäß dadurch gelöst, dass der erste und der zweite Messstromwandler als allstromsensitive Messstromwandler (Messstromwandler vom Typ B) ausgeführt sind und das Isolationsfehlersuchgerät eine Auswerteeinheit aufweist, welche Differenzstromanteile rechnerisch mittelbar kompensiert.

In dieser weiteren Alternativlösung ohne Anwendung einer Einstelleinrichtung zur Erhöhung einer Versorgungsspannung können beliebige Messstromwandler des Typs B eingesetzt werden. Das Isolationsfehlersuchgerät ist dahingehend modifiziert, dass es eine Auswerteeinheit aufweist, die eine Auswertung der von den Messstromwandlern gelieferten Messsignale durch rechnerische Subtraktion vornimmt und somit primärseitig erfasste, entgegengerichtete Differenzströme, insbesondere neben den reinen Wechselstrom-Differenzströmen auch Gleichstrom- und niederfrequente Differenzstromanteile, mittelbar kompensiert.

Isolationsfehlersuchsystem D: Die Aufgabe wird weiterhin auf Basis eines der Isolationsfehlersuchsysteme Cl, C2, oder C3 gelöst, wobei als ergänzende Kompensationseinrichtung der Widerstandspfad des Isolationsfehlersuchsystems A oder der Strompfad mit einer Stromeinstelleinrichtung des Isolationsfehlersuchsystems B installiert ist.

Die Isolationsfehlersuchsysteme C.1, C.2 und C.3 - die keine Einstelleinrichtung zur Erhöhung einer Versorgungsspannung aufweisen, wohl aber mit allstromsensitiven Messstromwandlern (Messstromwandler des Typs B) ausgestattet sind -, können somit als zusätzliche Kompensationsmaßnahme den Widerstandspfad (Isolationsfehlersuchsystem A) oder den Strompfad mit einer Stromeinstelleinrichtung (Isolationsfehlersuchsystem B) umfassen. Es erfolgt somit neben der mittelbaren, sekundärseitigen Kompensation der Differenzstromanteile eine direkte primärseitige Kompensation der Gleichstrom-Differenzströme mittels passivem Widerstandspfad oder aktivem Strompfad.

Der Vorteil dieser kombinierten Ausführung liegt darin begründet, dass für die Kompensation des störenden Gleichstrom-Differenzstroms die Anforderungen an den Dynamikbereich der Typ B Messstromwandler geringer sind. Es können kleinere und damit verbunden auch kostengünstigere Stromwandler zum Einsatz kommen, da die Kompensation zu einem Teil durch den Widerstandspfad oder den Strompfad mit einer Stromeinstelleinrichtung übernommen wird.

Die vorgenannten Isolationsfehlersuchsysteme C.1, C.2, C.3 und D ermöglichen es, unter Verwendung von Messstromwandlern des Typs B die Anforderungen an diese Messstromwandler hinsichtlich des Dynamikbereiches deutlich zu reduzieren und somit bei geringeren Kosten dennoch eine hohe Empfindlichkeit und Zuverlässigkeit bei der Fehlerortung in Dioden-gekoppeltes Gleichstrom-Stromversorgungssystemen zu realisieren.

Alle beschriebenen Isolationsfehlersuchsysteme A, B, C.1, C.2, C.3 und D stellen jeweils eine gerätetechnische Umsetzung eines Verfahrens zur Isolationsfehlersuche in einem ungeerdeten Gleichstrom-Stromversorgungssystem dar.

Den erfindungsgemäß beanspruchten Isolationsfehlersuchsystemen A, B, C.1, C.2, C.3 und D liegen damit entsprechende Verfahren zur Isolationsfehlersuche A, B, C.1, C.2, C.3 und D gemäß den Ansprüchen 8, 9, 11, 12, 13 und 14 zugrunde, aus denen sich die genannten vorteilhaften technischen Wirkungen ergeben.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: ein ungeerdetes Stromversorgungssystem mit Diodengekoppelter, redundanter Gleichspannungs-Versorgung und mit funktionalen Elementen eines Isolationsfehlersuchsystems nach dem Stand der Technik,
- **Fig. 2:**: das ungeerdete Stromversorgungsystem mit einem erfindungsgemäßen Isolationsfehlersuchsystem A,
- **Fig. 3:**: das ungeerdete Stromversorgungsystem mit einem erfindungsgemäßen Isolationsfehlersuchsystem B,
- **Fig. 4:**: das ungeerdete Stromversorgungsystem mit einem erfindungsgemäßen Isolationsfehlersuchsystem C.1,
- **Fig. 5:**: das ungeerdete Stromversorgungsystem mit einem erfindungsgemäßen Isolationsfehlersuchsystem C.2,
- **Fig. 6:**: das ungeerdete Stromversorgungsystem mit einem erfindungsgemäßen Isolationsfehlersuchsystem C.3 und
- **Fig. 7:**: das ungeerdete Stromversorgungsystem mit einem erfindungsgemäßen Isolationsfehlersuchsystem D.

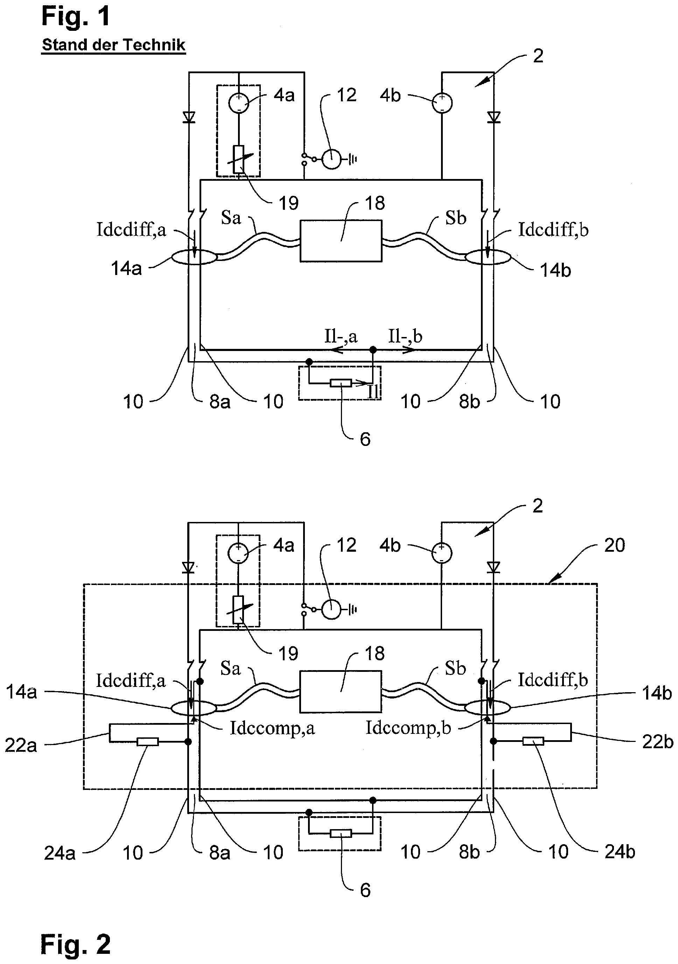

In **Fig. 1** ist ein ungeerdetes Gleichstrom-Stromversorgungssystem 2, dargestellt, welches redundant aus einer ersten Dioden-gekoppelten Gleichspannungs-Versorgungsquelle 4a und einer zweiten Dioden-gekoppelten Gleichspannungs-Versorgungsquelle 4b gespeist ist. Ein Verbraucher 6 ist über zwei redundante, räumlich getrennte Zuleitungen 8a, 8b, welche jeweils aus zwei aktiven Leitern 10 bestehen, an das Gleichstrom-Stromversorgungssystem 2 angeschlossen.

Nachdem von einem Isolationsüberwachungsgerät (nicht dargestellt) ein Isolationsfehler gemeldet wurde, wird die Isolationsfehlersuche gestartet, indem ein Prüfstromgenerator 12 einen Prüfstrom an zentraler Stelle alternierend in die aktiven Leiter 10 des Gleichstrom-Stromversorgungssystems 2 einerseits und Erde andererseits einspeist.

Zur Verfolgung des Prüfstromkreises (Fehlerstromkreises) sind ein erster Messstromwandler 14a zur Erfassung eines in der ersten Zuleitung 8a fließenden ersten Prüfstromanteils und ein zweiter Messstromwandler 14b zur Erfassung eines in der zweiten Zuleitung 8b fließenden zweiten Prüfstromanteils installiert. Die Messstromwandler 14a, 14b sind zur Auswertung von bereitgestellten Messsignalen Sa, Sb mit einem Isolationsfehlersuchgerät 18 verbunden.

Mit einer in der Gleichspannungs-Versorgungsquelle 4a integrierten Einstelleinrichtung 19 wird die Versorgungsspannung direkt an der ersten Gleichspannungs-Versorgungsquelle 4a erhöht, um eine wechselseitige Modulation der Quellenspannungen der Gleichspannungs-Versorgungsquellen 4a, 4b zu unterdrücken und damit die Entstehung Prüfstrom störender Differenzströme zu unterbinden.

Die Einstelleinrichtung 19 ist zur Einstellung nur einer der beiden Gleichspannungs-Versorgungsquellen 4a oder 4b erforderlich; könnte also auch an der Gleichspannungs-Versorgungsquelle 4b, statt, wie beispielhaft in Fig. 1, an der Gleichspannungs-Versorgungsquelle 4a angeordnet sein.

Die Erhöhung der Versorgungsspannung führt im Zusammenwirken mit der unsymmetrischen Laststromteilung - Aufteilung des Laststroms I1 in die ungleichen Teil-Lastströme I1-,a und I1-,b - in den betreffenden Zuleitungen 8a, 8b zu Gleichstrom-Differenzströmen Idcdiff,a, Idcdiff,b, die die Erfassung des Prüfstroms durch die Messstromwandler 14a, 14b empfindlich stören können

Grundsätzlich könnten statt einer einseitigen geringfügigen Erhöhung der Versorgungsspannung zur Erzielung der gleichen Wirkung auch die Durchlassspannungen der Koppeldioden hinreichend unterschiedlich groß gewählt werden oder eine der Dioden durch eine Reihenschaltung mehrerer Dioden ersetzt werden.

**Fig. 2** zeigt das ungeerdete Stromversorgungsystem 2 mit einem erfindungsgemäßen Isolationsfehlersuchsystem A 20.

Das Isolationsfehlersuchsystem A 20 umfasst neben den aus dem Stand der Technik bekannten funktionalen Blöcken Prüfstromgenerator 12, Einstelleinrichtung 19 zur Erhöhung einer Versorgungsspannung und Isolationsfehlersuchgerät 18 mit erstem und zweiten Messstromwandler 14a, 14b erfindungsgemäß jeweils einen in den Zuleitungen 8a, 8b zwischen den jeweiligen aktiven Leitern 10 angeordneten Widerstandspfad 22a, 22b.

Die Widerstandspfade 22a, 22b sind passiv ausgeführt und weisen einen Widerstand 24a, 24b auf, der jeweils so bemessen ist, dass ein Kompensationsstrom Idccomp,a, Idccomp,b in dem Widerstandspfad 22a, 22b fließt, der gleich dem durch die Erhöhung der Versorgungsspannung bewirkten störenden Gleichstrom-Differenzstrom Idcdiff,a, Idcdiff,b in der betreffenden Zuleitung 8a, 8b ist. Dabei werden die Kompensationsströme Idccomp,a, Idccomp,b in den Messstromwandlern 14a, 14b primärseitig in entgegengesetzter Richtung zu den störenden Gleichstrom-Differenzströmen Idcdiff,a, Idcdiff,b geführt, um die Gleichstrom-Differenzströme Idcdiff,a, Idcdiff,b zu kompensieren und damit Sättigungseffekte im Kernmaterial der Messstromwandler 14a, 14b zu vermeiden, die sonst durch unkompensierete Differenzströme Idcdiff,a, Idcdiff,b hervorgerufen würden.

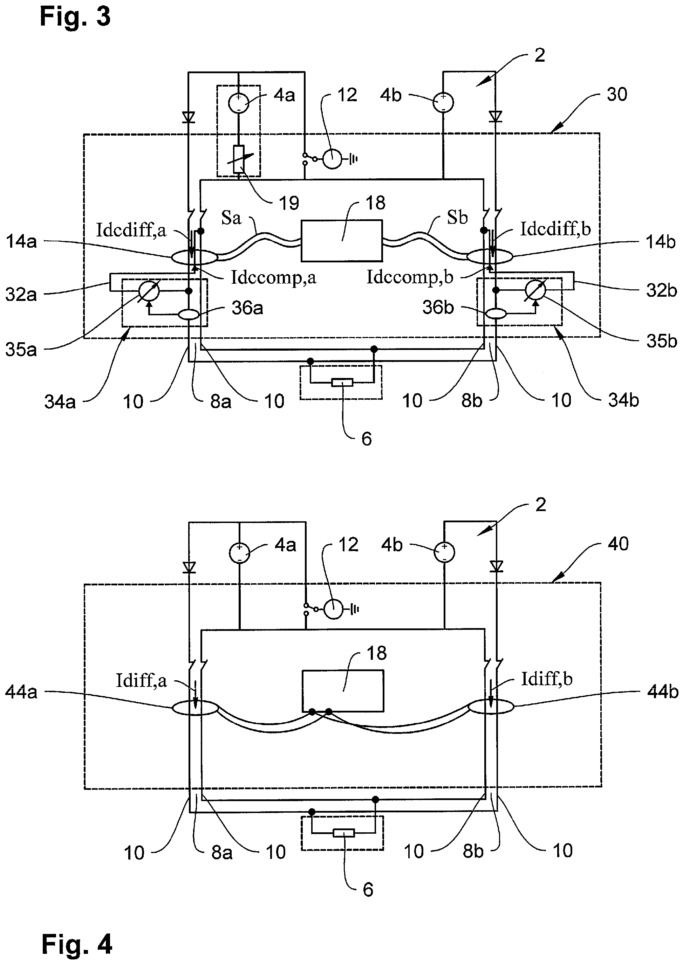

In **Fig.3** ist das ungeerdete Stromversorgungsystem 2 mit einem erfindungsgemäßen Isolationsfehlersuchsystem B 30 dargestellt.

Im Unterschied zu dem in Fig. 2 gezeigten Isolationsfehlersuchsystem A 20 weist das Isolationsfehlersuchsystem B 30 - statt eines passiven Widerstandspfades 22a, 22b - zwischen den aktiven Leitern 10 der ersten Zuleitung 8a und zwischen den aktiven Leitern 10 der zweiten Zuleitung 8b jeweils einen Strompfad 32a, 32b mit einer Stromeinstelleinrichtung 34a, 34b auf. Die Stromeinstelleinrichtung 34a, 34b umfasst eine einstellbare Stromquelle 35a, 35b zur Erzeugung des Kompensationsstroms Idccomp,a, Idccomp,b und einen Stromsensor 36a, 36b zur Gleichstrom-Laststrommessung auf.

Die Stromeinstelleinrichtungen 34a, 34b bewerkstelligen eine laststromabhängige Einstellung der Kompensationsströme Idccomp,a, Idccomp,b, um - wie bei dem Isolationsfehlersuchsystem A 20 - die Gleichstrom-Differenzströme Idcdiff,a, Idcdiff,b zu kompensieren.

**Fig. 4** zeigt das ungeerdete Stromversorgungsystem 2 mit einem erfindungsgemäßen Isolationsfehlersuchsystem C.1 40.

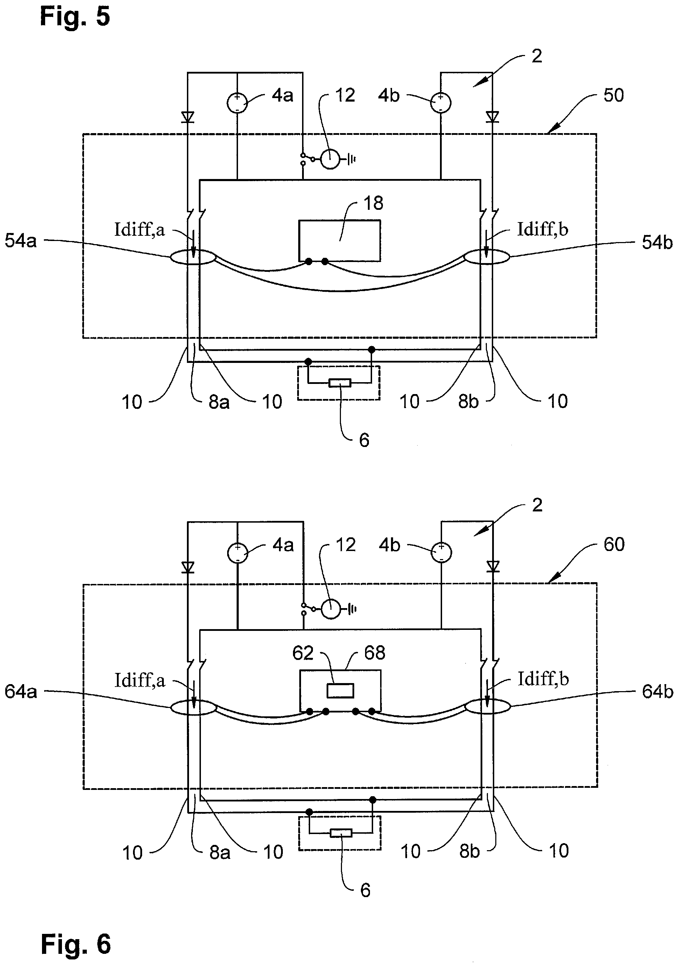

Im Unterschied zu dem zuvor beschriebenen Isolationsfehlersuchsystem A 20 (Fig. 2) und dem Isolationsfehlersuchsystem B 30 (Fig. 3) wird in dem Isolationsfehlersuchsystem C.1 40 (Fig. 4), dem Isolationsfehlersuchsystem C.2 50 (Fig. 5) und dem Isolationsfehlersuchsystem C.3 60 (Fig. 6) auf eine Erhöhung einer der Versorgungsspannungen der Gleichspannungs-Versorgungsquellen 4a, 4b durch eine Einstelleinrichtung 19 (Fig. 2, Fig. 3) verzichtet.

Stattdessen werden allstromsensitive Messstromwandler (Messstromwandler vom Typ B) mit Stromausgang 44a, 44b (Isolationsfehlersuchsystem C.1 40), mit Spannungsausgang 54a, 54b (Isolationsfehlersuchsystem C.2 50) und beliebige Typ B Messstromwandler 64a, 64b (Isolationsfehlersuchsystem C.3 60) eingesetzt, die eine Erfassung sämtlicher Wechselstrom- und Gleichstrom-Differenzstromanteile Idiff,a, Idiff,b ermöglichen.

Die Messstromwandler 44a, 44b des Isolationsfehlersuchsystems C.1 40 sind als Messstromwandler vom Typ B mit Stromausgang ausgeführt, sodass eine sekundärseitige Parallelschaltung (schaltungstechnische Subtraktion) an den Klemmen des Isolationsfehlersuchgerätes 18 eine Kompensation der Differenzstromanteile Idiff,a, Idiff,b bewirkt.

**Fig. 5** zeigt das ungeerdete Stromversorgungsystem 2 mit einem erfindungsgemäßen Isolationsfehlersuchsystem C.2 50.

Im Unterschied zu dem vorbeschriebenen Isolationsfehlersuchsystem C.1 40 in Fig. 4 werden in dem Isolationsfehlersuchsystem C.2 50 in Fig. 5 Messstromwandler 54a, 54b vom Typ B mit Spannungsausgang eingesetzt. Die Messstromwandler 54a, 54b sind sekundärseitig an den Klemmen des Isolationsfehlersuchgerätes 18 in Reihe geschaltet, sodass auch hier eine schaltungstechnische Subtraktion vorliegt, die störende Differenzstromanteile Idiff,a, Idiff,b kompensiert.

**Fig. 6** zeigt das ungeerdete Stromversorgungsystem 2 mit einem erfindungsgemäßen Isolationsfehlersuchsystem C.3 60.

In dem Isolationsfehlersuchsystem C.3 60 können beliebige Messstromwandler 64a, 64b vom Typ B verwendet werden, da die Auswertung der von den Messstromwandlern 64a, 64b bereitgestellten und getrennt aufgenommenen Messsignale rechnerisch vorgenommenen wird. Dazu weist das Isolationsfehlersuchgerät 68 eine Auswerteeinheit 62 auf.

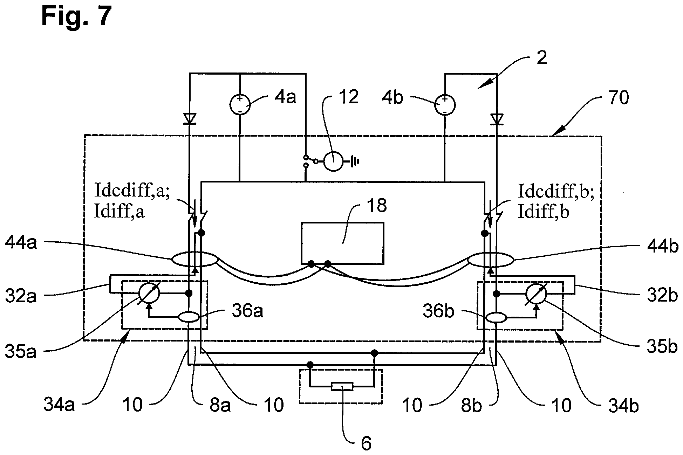

In **Fig. 7** ist das ungeerdete Stromversorgungsystem 2 mit einem erfindungsgemäßen Isolationsfehlersuchsystem D 70 gezeigt.

Das Isolationsfehlersuchsystem D 70 beruht auf einem der Isolationsfehlersuchsysteme C.1, C.2 oder C.3, weist somit keine Einstelleinrichtung 19 (Fig.1, Fig. 2) zur Erhöhung einer Versorgungsspannung auf, jedoch kommt eine direkte primärseitige Kompensation der Gleichstrom-Differenzströme Idcdiff,a, Idcdiff,b aus dem Isolationsfehlersuchsystem A 20 (Fig. 2) oder dem Isolationsfehlersuchsystem B 30 (Fig. 3) ergänzend zum Einsatz.

Beispielhaft sind in Fig. 7 die aktiven Strompfade 32a, 32b aus dem Isolationsfehlersuchsystem B 30 (Fig. 3) in das auf dem Isolationsfehlersuchsystem C.1 40 (Fig. 4) basierende Isolationsfehlersuchsystem D 70 integriert worden.

Das Isolationsfehlersuchsystem D 70 weist somit eine Kombination aus primärseitiger, laststromabhängiger Kompensation der Gleichstrom-Differenzströme Idcdiff,a, Idcdiff,b und sekundärseitiger (mittelbarer), schaltungstechnischer (hier Parallelschaltung) Kompensation von Differenzstromanteilen Idiff,a, Idiff,b auf.

Der Vorteil gegenüber einer alleinigen Anwendung eines der Isolationsfehlersuchsysteme ist, dass die zur Durchführung der Kompensation gestellten Anforderungen an den Dynamikbereich der Typ B Messstromwandler geringer sind. Es können kleinere und damit verbunden auch kostengünstigere Messstromwandler zum Einsatz kommen.

## Patentansprüche

1. Isolationsfehlersuchsystem (20) für ein ungeerdetes Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend eine Einstelleinrichtung (19) zur Erhöhung einer Versorgungsspannung der ersten oder der zweiten Gleichspannungs-Versorgungsquelle (4a, 4b), einen Prüfstromgenerator (12) zur Einspeisung eines Prüfstroms und ein Isolationsfehlersuchgerät (18), an welches ein erster Messstromwandler (14a) zur Erfassung eines in der ersten Zuleitung (8a) fließenden ersten Prüfstromanteils und ein zweiter Messstromwandler (14b) zur Erfassung eines in der zweiten Zuleitung (8b) fließenden zweiten Prüfstromanteils angeschlossen sind,
**dadurch gekennzeichnet,**
**dass** zwischen den aktiven Leitern (10) der ersten Zuleitung (8a) ein erster Widerstandspfad (22a) und zwischen den aktiven Leitern (10) der zweiten Zuleitung (8b) ein zweiter Widerstandspfad (22b) angeordnet ist, deren jeweiliger elektrischer Widerstand (24a, 24b) so dimensioniert ist, dass ein Kompensationsstrom (Idccomp,a, Idccomp,b) in dem jeweiligen Widerstandspfad (22a, 22b) fließt, der gleich einem durch die Erhöhung der Versorgungsspannung bewirkten störenden Gleichstrom-Differenzstrom (Idcdiff,a, Idcdiff,b) in der betreffenden Zuleitung (8a, 8b) ist und der von dem jeweiligen Messstromwandler (14a, 14b) in entgegengesetzter Richtung des Gleichstrom-Differenzstroms (Idcdiff,a, Idcdiff,b) primärseitig erfasst wird.

2. Isolationsfehlersuchsystem (30) für ein ungeerdetes Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend eine Einstelleinrichtung (19) zur Erhöhung einer Versorgungsspannung der ersten oder der zweiten Gleichspannungs-Versorgungsquelle, einen Prüfstromgenerator (12) zur Einspeisung eines Prüfstroms und ein Isolationsfehlersuchgerät (18), an welches ein erster Messstromwandler (14a) zur Erfassung eines in der ersten Zuleitung fließenden ersten Prüfstromanteils und ein zweiter Messstromwandler (14b) zur Erfassung eines in der zweiten Zuleitung fließenden zweiten Prüfstromanteils angeschlossen sind,
**dadurch gekennzeichnet,**
**dass** zwischen den aktiven Leitern der ersten Zuleitung (8a) und zwischen den aktiven Leitern der zweiten Zuleitung (8b) jeweils ein Strompfad (32a, 32b) mit einer Stromeinstelleinrichtung (34a, 34b) angeordnet ist, die eingerichtet ist, laststromabhängig einen Kompensationsstrom (Idccomp,a, Idccomp,b) einzustellen, der gleich einem durch die Erhöhung der Versorgungsspannung bewirkten störenden Gleichstrom-Differenzstrom (Idcdiff,a, Idcdiff,b) in der betreffenden Zuleitung (8a, 8b) ist und der von dem jeweiligen Messstromwandler (14a, 14b) in entgegengesetzter Richtung des Gleichstrom-Differenzstroms (Idcdiff,a, Idcdiff,b) primärseitig erfasst wird.

3. Isolationsfehlersuchsystem nach Anspruch 2,
**dadurch gekennzeichnet,**
**dass** die Stromeinstelleinrichtung (34a, 34b) eine einstellbare Stromquelle (35a, 35b) zur Erzeugung des Kompensationsstroms und einen Stromsensor (36a, 36b) zur Gleichstrom-Laststrommessung aufweist.

4. Isolationsfehlersuchsystem (40) für ein ungeerdetes Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend einen Prüfstromgenerator (12) zur Einspeisung eines Prüfstroms und ein Isolationsfehlersuchgerät (18), an welches ein erster Messstromwandler (44a) zur Erfassung eines in der ersten Zuleitung (8a) fließenden ersten Prüfstromanteils und ein zweiter Messstromwandler (44b) zur Erfassung eines in der zweiten Zuleitung (8b) fließenden zweiten Prüfstromanteils angeschlossen sind,
**dadurch gekennzeichnet,**
**dass** der erste und der zweite Messstromwandler (44a, 44b) als allstromsensitive Messstromwandler mit Stromausgang ausgeführt sind und sekundärseitig parallel geschaltet sind zur mittelbaren Kompensation von Differenzstromanteilen (Idiff,a, Idiff,b).

5. Isolationsfehlersuchsystem (50) für ein ungeerdetes Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend einen Prüfstromgenerator (12) zur Einspeisung eines Prüfstroms und ein Isolationsfehlersuchgerät (18), an welches ein erster Messstromwandler (54a) zur Erfassung eines in der ersten Zuleitung (8a) fließenden ersten Prüfstromanteils und ein zweiter Messstromwandler (54b) zur Erfassung eines in der zweiten Zuleitung (8b) fließenden zweiten Prüfstromanteils angeschlossen sind,
**dadurch gekennzeichnet,**
**dass** der erste und der zweite Messstromwandler (54a, 54b) als allstromsensitive Messstromwandler mit Spannungsausgang ausgeführt sind und sekundärseitig in Reihe geschaltet sind zur mittelbaren Kompensation von Differenzstromanteilen (Idiff,a, Idiff,b).

6. Isolationsfehlersuchsystem (60) für ein ungeerdetes Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend einen Prüfstromgenerator (12) zur Einspeisung eines Prüfstroms und ein Isolationsfehlersuchgerät (68), an welches ein erster Messstromwandler (64a) zur Erfassung eines in der ersten Zuleitung (8a) fließenden ersten Prüfstromanteils und ein zweiter Messstromwandler (64b) zur Erfassung eines in der zweiten Zuleitung (8b) fließenden zweiten Prüfstromanteils angeschlossen sind,
**dadurch gekennzeichnet,**
**dass** der erste und der zweite Messstromwandler (64a, 64b) als allstromsensitive Messstromwandler ausgeführt sind und das Isolationsfehlersuchgerät (68) eine Auswerteeinheit (62) aufweist, welche eingerichtet ist, Differenzstromanteile (Idiff,a, Idiff,b) rechnerisch mittelbar zu kompensieren.

7. Isolationsfehlersuchsystem nach einem der Ansprüche 4 bis 6,
**dadurch gekennzeichnet,**
**dass** als ergänzende Kompensationseinrichtung der Widerstandspfad nach Anspruch 1 oder der Strompfad mit einer Stromeinstelleinrichtung nach den Ansprüchen 2 oder 3 installiert ist.

8. Verfahren zur Isolationsfehlersuche in einem ungeerdeten Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend die Verfahrensschritte:
- Erhöhen einer Versorgungsspannung der ersten Gleichspannungs-Versorgungsquelle (4a) oder der zweiten Gleichspannungs-Versorgungsquelle (4b) mit einer Einstelleinrichtung (19),
- Einspeisen eines Prüfstroms mit einem Prüfstromgenerator (12),
- Erfassen eines in der ersten Zuleitung (8a) fließenden ersten Prüfstromanteils mit einem an ein Isolationsfehlersuchgerät (18) angeschlossenen ersten Messstromwandler (14a) und Erfassen eines in der zweiten Zuleitung (8b) fließenden zweiten Prüfstromanteils mit einem an das Isolationsfehlersuchgerät (18) angeschlossenen zweiten Messstromwandler (14b),
**gekennzeichnet durch**
- Erzeugen eines von den Gleichspannungs-Versorgungsquellen (4a, 4b) getriebenen ersten Kompensationsstroms (Idccomp,a) in einem ersten Widerstandspfad (22a) zwischen den aktiven Leitern (10) der ersten Zuleitung (8a) und Erzeugen eines von den Gleichspannungs-Versorgungsquellen (4a, 4b) getriebenen zweiten Kompensationsstroms (Idccomp,b) in einem zweiten Widerstandspfad (22b) zwischen den aktiven Leitern (10) der zweiten Zuleitung (8b), wobei der jeweilige Kompensationsstrom (Idccomp,a, Idccomp,b) gleich einem durch die Erhöhung der Versorgungsspannung bewirkten störenden Gleichstrom-Differenzstrom (Idcdiff,a, Idcdiff,b) in der betreffenden Zuleitung (8a, 8b) ist und von dem jeweiligen Messstromwandler (14a, 14b) in entgegengesetzter Richtung des Gleichstrom-Differenzstroms (Idcdiff,a, Idcdiff,b) primärseitig erfasst wird.

9. Verfahren zur Isolationsfehlersuche in einem ungeerdeten Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4a) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend die Verfahrensschritte:
- Erhöhen einer Versorgungsspannung der ersten Gleichspannungs-Versorgungsquelle (4a) oder der zweiten Gleichspannungs-Versorgungsquelle (4b) mit einer Einstelleinrichtung (19),
- Einspeisen eines Prüfstroms mit einem Prüfstromgenerator (12),
- Erfassen eines in der ersten Zuleitung (8a) fließenden ersten Prüfstromanteils mit einem an ein Isolationsfehlersuchgerät (18) angeschlossenen ersten Messstromwandler (14a) und Erfassen eines in der zweiten Zuleitung (8b) fließenden zweiten Prüfstromanteils mit einem an das Isolationsfehlersuchgerät (18) angeschlossenen zweiten Messstromwandler (14b),
**gekennzeichnet durch**
- Erzeugen und Einstellen eines laststromabhängigen Kompensationsstroms (Idccomp,a, Idccomp,b) jeweils in einem Strompfad (32a, 32b) zwischen den aktiven Leitern (10) der ersten Zuleitung (8a) und zwischen den aktiven Leitern (10) der zweiten Zuleitung (8b) mittels einer Stromeinstelleinrichtung (34a, 34b), wobei der jeweilige Kompensationsstrom (Idccomp,a, Idccomp,b) gleich einem durch die Erhöhung der Versorgungsspannung bewirkten störenden Gleichstrom-Differenzstrom (Idcdiff,a, Idcdiff,b) in der betreffenden Zuleitung (8a, 8b) ist und der von dem jeweiligen Messstromwandler (14a, 14b) in entgegengesetzter Richtung des Gleichstrom-Differenzstroms (Idcdiff,a, Idcdiff,b) primärseitig erfasst wird.

10. Verfahren zur Isolationsfehlersuche nach Anspruch 9,
**dadurch gekennzeichnet,**
**dass** das Erzeugen und Einstellen des laststromabhängigen Kompensationsstroms mittels einer einstellbaren Stromquelle erfolgt und eine Gleichstrom-Laststrommessung mittels eines Stromsensors durchgeführt wird.

11. Verfahren zur Isolationsfehlersuche in einem ungeerdeten Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend die Verfahrensschritte:
- Einspeisen eines Prüfstroms mit einem Prüfstromgenerator (12),
- Erfassen eines in der ersten Zuleitung (8a) fließenden ersten Prüfstromanteils mit einem an ein Isolationsfehlersuchgerät (18) angeschlossenen ersten Messstromwandler (44a) und Erfassen eines in der zweiten Zuleitung (8b) fließenden zweiten Prüfstromanteils mit einem an das Isolationsfehlersuchgerät (18) angeschlossenen zweiten Messstromwandler (44b),
**gekennzeichnet durch**
- Sekundärseitiges Parallelschalten der als allstromsensitive Messstromwandler mit Stromausgang ausgeführten ersten und zweiten Messstromwandlers (44a, 44b) zum mittelbaren Kompensieren von Differenzstromanteilen (Idiff,a, Idiff,b).

12. Verfahren zur Isolationsfehlersuche in einem ungeerdeten Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend die Verfahrensschritte:
- Einspeisen eines Prüfstroms mit einem Prüfstromgenerator (12),
- Erfassen eines in der ersten Zuleitung (8a) fließenden ersten Prüfstromanteils mit einem an ein Isolationsfehlersuchgerät (18) angeschlossenen ersten Messstromwandler (54a) und Erfassen eines in der zweiten Zuleitung (8b) fließenden zweiten Prüfstromanteils mit einem an das Isolationsfehlersuchgerät (18) angeschlossenen zweiten Messstromwandler (54b),
**gekennzeichnet durch**
- Sekundärseitiges In-Reihe-Schalten der als allstromsensitive Messstromwandler mit Spannungsausgang ausgeführten ersten und zweiten Messstromwandlers (54a, 54b) zum mittelbaren Kompensieren von Differenzstromanteilen (Idiff,a, Idiff,b).

13. Verfahren zur Isolationsfehlersuche in einem ungeerdeten Gleichstrom-Stromversorgungssystem (2), welches redundant aus einer ersten Dioden-gekoppelten Gleichspannungs-Versorgungsquelle (4a) und einer zweiten Dioden-gekoppelten Gleichspannungs-Versorgungsquelle (4b) gespeist ist und an das ein Verbraucher (6) redundant über eine erste aus zwei aktiven Leitern (10) bestehende Zuleitung (8a) und eine zweite aus zwei aktiven Leitern (10) bestehende Zuleitung (8b) angeschlossen ist, umfassend die Verfahrensschritte:
- Einspeisen eines Prüfstroms mit einem Prüfstromgenerator (12),
- Erfassen eines in der ersten Zuleitung (8a) fließenden ersten Prüfstromanteils mit einem an ein Isolationsfehlersuchgerät (68) angeschlossenen ersten Messstromwandler (64a) und Erfassen eines in der zweiten Zuleitung (8b) fließenden zweiten Prüfstromanteils mit einem an das Isolationsfehlersuchgerät (68) angeschlossenen zweiten Messstromwandler (64b),
**gekennzeichnet durch**
- Auswerten der von den allstromsensitiv ausgeführten Messstromwandlern (64a, 64b) bereitgestellten Messsignale durch rechnerisches mittelbares Kompensieren von Differenzstromanteilen (Idiff,a, Idiff,b).

14. Verfahren zur Isolationsfehlersuche nach einem der Ansprüche 11 bis 13,
**dadurch gekennzeichnet,**
**dass** als ergänzende Verfahrensschritte zum Kompensieren des störenden Gleichstrom-Differenzstroms das Erzeugen eines von den Gleichspannungs-Versorgungsquellen getriebenen Kompensationsstroms in einem Widerstandspfad nach Anspruch 8 oder das Erzeugen und Einstellen eines laststromabhängigen Kompensationsstroms in einem Strompfad nach den Ansprüchen 9 oder 10 erfolgen.

## Claims

1. An insulation fault location system (20) for an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), the insulation fault location system (20) comprising a setting device (19) for increasing a supply voltage of the first or the second direct voltage supply source (4a, 4b), a test current generator (12) for supplying a test current and an insulation fault location apparatus (18), to which a first measuring current transformer (14a) for capturing a first test current portion flowing in the first supply line (8a) and a second measuring current transformer (14b) for capturing a second test current portion flowing in the second supply line (8b) are coupled,
**characterized in that**
a first resistance path (22a) is arranged between the active conductors (10) of the first supply line (8a) and a second resistance path (22b) is arranged between the active conductors (10) of the second supply line (8b), the electric resistance (24a, 24b) of each resistance path (22a, 22b) being dimensioned such that a compensating current (Idccomp,a, Idccomp,b) flows in the respective resistance path (22a, 22b), said compensating current (Idccomp,a, Idccomp,b) being equal to an interfering DC differential current (Idcdiff,a, Idcdiff,b) in the respective supply line (8a, 8b) caused by increasing the supply voltage and being captured on the primary side in the opposite direction of the DC differential current (Idcdiff,a, Idcdiff,b) by the respective measuring current transformer (14a, 14b).

2. An insulation fault location system (30) for an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), the insulation fault location system (30) comprising a setting device (19) for increasing a supply voltage of the first or the second direct voltage supply source, a test current generator (12) for supplying a test current and an insulation fault location apparatus (18), to which a first measuring current transformer (14a) for capturing a first test current portion flowing in the first supply line and a second measuring current transformer (14b) for capturing a second test current portion flowing in the second supply line are coupled,
**characterized in that**
a current path (32a, 32b) having a current setting device (34a, 34b) is arranged between the active conductors of the first supply line (8a) and between the active conductors of the second supply line (8b), respectively, said current setting device (34a, 34b) being configured to set a compensating current (Idccomp,a, Idccomp,b) dependent on load current, said compensating current (Idccomp,a, Idccomp,b) being equal to an interfering DC differential current (Idcdiff,a, Idcdiff,b) in the respective supply line (8a, 8b) caused by increasing the supply voltage and being captured on the primary side in the opposite direction of the DC differential current (Idcdiff,a, Idcdiff,b) by the respective measuring current transformer (14a, 14b).

3. The insulation fault location system according to claim 2,
**characterized in that**
the current setting device (34a, 34b) comprises a settable current source (35a, 35b) for generating the compensating current and a current sensor (36a, 36b) for measuring DC load current.

4. An insulation fault location system (40) for an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), the insulation fault location system (40) comprising a test current generator (12) for supplying a test current and an insulation fault location apparatus (18), to which a first measuring current transformer (44a) for capturing a first test current portion flowing in the first supply line (8a) and a second measuring current transformer (44b) for capturing a second test current portion flowing in the second supply line (8b) are coupled,
**characterized in that**
the first measuring current transformer (44a) and the second measuring current transformer (44b) are configured as all-current sensitive measuring current transformers having a current output and are connected in parallel on the secondary side for indirectly compensating differential current portions (Idiff,a, Idiff,b).

5. An insulation fault location system (50) for an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), the insulation fault location system (50) comprising a test current generator (12) for supplying a test current and an insulation fault location apparatus (18), to which a first measuring current transformer (54a) for capturing a first test current portion flowing in the first supply line (8a) and a second measuring current transformer (54b) for capturing a second test current portion flowing in the second supply line (8b) are coupled,
**characterized in that**
the first measuring current transformer (54a) and the second measuring current transformer (54b) are configured as all-current sensitive measuring current transformers having a voltage output and are connected in series on the secondary side for indirectly compensating differential current portions (Idiff,a, Idiff,b).

6. An insulation fault location system (60) for an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), the insulation fault location system (60) comprising a test current generator (12) for supplying a test current and an insulation fault location apparatus (68), to which a first measuring current transformer (64a) for capturing a first test current portion flowing in the first supply line (8a) and a second measuring current transformer (64b) for capturing a second test current portion flowing in the second supply line (8b) are coupled,
**characterized in that**
the first measuring current transformer (64a) and the second measuring current transformer (64b) are configured as all-current sensitive measuring current transformers, and the insulation fault location apparatus (68) comprises an evaluation unit (62), which is configured to indirectly compensate differential current portions (Idiff,a, Idiff,b) computationally.

7. The insulation fault location system according to any one of claims 4 to 6,
**characterized in that**
the resistance path according to claim 1 or the current path having a current setting device according to claim 2 or 3 is installed as a complementary compensational device.

8. A method for insulation fault location in an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), comprising the method steps:
- increasing a supply voltage of the first direct voltage supply source (4a) or the second direct voltage supply source (4b) using a setting device (19),
- supplying a test current using a test current generator (12),
- capturing a first test current portion flowing in the first supply line (8a) using a first measuring current transformer (14a) coupled to an insulation fault location apparatus (18), and capturing a second test current portion flowing in the second supply line (8b) using a second measuring current transformer (14b) coupled to the insulation fault location apparatus (18),
**characterized by**
- generating a first compensating current (Idccomp,a) driven by the direct voltage supply sources (4a, 4b) in a first resistance path (22a) between the active conductors (10) of the first supply line (8a), and generating a second compensating current (Idccomp,b) driven by the direct voltage supply sources (4a, 4b) in a second resistance path (22b) between the active conductors (10) of the second supply line (8b), the respective compensating current (Idccomp,a, Idccomp,b) being equal to an interfering DC differential current (Idcdiff,a, Idcdiffb) in the respective supply line (8a, 8b) caused by increasing the supply voltage and being captured on the primary side in the opposite direction of the DC differential current (Idcdiff,a, Idcdiff,b) by the respective measuring current transformer (14a, 14b).

9. A method for insulation fault location in an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), comprising the method steps:
- increasing a supply voltage of the first direct voltage supply source (4a) or the second direct voltage supply source (4b) using a setting device (19),
- supplying a test current using a test current generator (12),
- capturing a first test current portion flowing in the first supply line (8a) using a first measuring current transformer (14a) coupled to an insulation fault location apparatus (18), and capturing a second test current portion flowing in the second supply line (8b) using a second measuring current transformer (14b) coupled to the insulation fault location apparatus (18),
**characterized by**
- generating and setting a compensating current (Idccomp,a, Idccomp,b) dependent on load current in a current path (32a, 32b) between the active conductors (10) of the first supply line (8a) and between the active conductors (10) of the second supply line (8b), respectively, by means of current setting device (34a, 34b), the respective compensating current (Idccomp,a, Idccomp,b) being equal to an interfering DC differential current (Idcdiff,a, Idcdiff,b) in the respective supply line (8a, 8b) caused by increasing the supply voltage and being captured on the primary side in the opposite direction of the DC differential current (Idcdiff,a, Idcdiff,b) by the respective measuring current transformer (14a, 14b).

10. The method for insulation fault location according to claim 9, **characterized in that**
the compensating current dependent on load current is generated and set by means of a settable current source and a DC load current is measured by means of a current sensor.

11. A method for insulation fault location in an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), comprising the method steps:
- supplying a test current using a test current generator (12),
- capturing a first test current portion flowing in the first supply line (8a) using a first measuring current transformer (44a) coupled to an insulation fault location apparatus (18), and capturing a second test current portion flowing in the second supply line (8b) using a second measuring current transformer (44b) coupled to the insulation fault location apparatus (18),
**characterized by**
- connecting the first measuring current transformer (44a) and the second measuring current transformer (44b), which are configured as all-current sensitive measuring current transformers having a current output, in parallel on the secondary side for indirectly compensating differential current portions (Idiff,a, Idiff,b).

12. A method for insulation fault location in an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), comprising the method steps:
- supplying a test current using a test current generator (12)
- capturing a first test current portion flowing in the first supply line (8a) using a first measuring current transformer (54a) coupled to an insulation fault location apparatus (18), and capturing a second test current portion flowing in the second supply line (8b) using a second measuring current transformer (54b) coupled to the insulation fault location apparatus (18),
**characterized by**
- connecting the first measuring current transformer (54a) and the second measuring current transformer (54b), which are configured as all-current sensitive measuring current transformers having a voltage output, in series on the secondary side for indirectly compensating differential current portions (Idiff,a, Idiff,b).

13. A method for insulation fault location in an ungrounded DC power supply system (2), which is redundantly fed from a first diode-coupled direct voltage supply source (4a) and a second diode-coupled direct voltage supply source (4b) and to which a load (6) is redundantly coupled via a first supply line (8a) consisting of two active conductors (10) and a second supply line (8b) consisting of two active conductors (10), comprising the method steps:
- supplying a test current using a test current generator (12),
- capturing a first test current portion flowing in the first supply line (8a) using a first measuring current transformer (64a) coupled to an insulation fault location apparatus (68), and capturing a second test current portion flowing in the second supply line (8b) using a second measuring current transformer (64b) coupled to the insulation fault location apparatus (68),
**characterized by**
- evaluating the measuring signals, which are provided by the measuring current transformers (64a, 64b) configured to be all-current sensitive, by indirectly compensating differential current portions (Idiff,a, Idiff,b) computationally.

14. The method for insulation fault location according to any one of claims 11 to 13,
**characterized in that**
as supplementary method steps for compensating the interfering DC differential current, a compensating current driven by the direct voltage supply sources is generated in a resistance path according to claim 8 or a compensating current dependent on load current is generated and set in a current path according to claim 9 or 10.

## Revendications

1. Système de localisation de défauts d'isolement (20) pour un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le système de localisation de défauts d'isolement (20) comprenant un dispositif de réglage (19) pour augmenter une tension d'alimentation de la première ou la deuxième source de tension continue (4a, 4b), un générateur de courant de test (12) pour injecter un courant de test et un dispositif de localisation de défauts d'isolement (18), auquel un premier transformateur de courant de mesure (14a) pour détecter une première partie de courant de test traversant la première ligne d'alimentation (8a) et un deuxième transformateur de courant de mesure (14b) pour détecter une deuxième partie de courant de test traversant la deuxième ligne d'alimentation (8b) sont couplés,
**caractérisé en ce**
**qu'**un premier chemin résistif (22a) est disposé entre les conducteurs actifs (10) de la première ligne d'alimentation (8a) et un deuxième chemin résistif (22b) est disposé entre les conducteurs actifs (10) de la deuxième ligne d'alimentation (8b), la résistance électrique (24a, 24b) de chaque chemin résistif (22a, 22b) étant dimensionnée de telle manière qu'un courant de compensation (Idccomp,a, Idccomp,b) traverse le chemin résistif (22a, 22b) respectif, ledit courant de compensation (Idccomp,a, Idccomp,b) étant égal à un courant continu différentiel (Idcdiff,a, Idcdiff,b) parasite dans la ligne d'alimentation (8a, 8b) respective provoqué par l'augmentation de la tension d'alimentation et étant détecté du côté primaire dans la direction opposée du courant continu différentiel (Idcdiff,a, Idcdiff,b) par le transformateur de courant de mesure (14a, 14b) respectif.

2. Système de localisation de défauts d'isolement (30) pour un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le système de localisation de défauts d'isolement (30) comprenant un dispositif de réglage (19) pour augmenter une tension d'alimentation de la première ou la deuxième source de tension continue, un générateur de courant de test (12) pour injecter un courant de test et un dispositif de localisation de défauts d'isolement (18), auquel un premier transformateur de courant de mesure (14a) pour détecter une première partie de courant de test traversant la première ligne d'alimentation et un deuxième transformateur de courant de mesure (14b) pour détecter une deuxième partie de courant de test traversant la deuxième ligne d'alimentation sont couplés,
**caractérisé en ce que**
un chemin de courant (32a, 32b) ayant un dispositif de réglage de courant (34a, 34b) est respectivement disposé entre les conducteurs actifs de la première ligne d'alimentation (8a) et entre les conducteurs actifs de la deuxième ligne d'alimentation (8b), ledit dispositif de réglage de courant (34a, 34b) étant configuré pour régler un courant de compensation (Idccomp,a, Idccomp,b) en fonction d'un courant de charge, ledit courant de compensation (Idccomp,a, Idccomp,b) étant égal à un courant continu différentiel (Idcdiff,a, Idcdiff,b) parasite dans la ligne d'alimentation (8a, 8b) respective provoqué par l'augmentation de la tension d'alimentation et étant détecté du côté primaire dans la direction opposée du courant continu différentiel (Idcdiff,a, Idcdiff,b) par le transformateur de courant de mesure (14a, 14b) respectif.

3. Système de localisation de défauts d'isolement selon la revendication 2,
**caractérisé en ce que**
le dispositif de réglage de courant (34a, 34b) comprend une source de courant (35a, 35b) réglable pour générer le courant de compensation et un capteur de courant (36a, 36b) pour mesurer un courant continue de charge.

4. Système de localisation de défauts d'isolement (40) pour un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le système de localisation de défauts d'isolement (40) comprenant un générateur de courant de test (12) pour injecter un courant de test et un dispositif de localisation de défauts d'isolement (18), auquel un premier transformateur de courant de mesure (44a) pour détecter une première partie de courant de test traversant la première ligne d'alimentation (8a) et un deuxième transformateur de courant de mesure (44b) pour détecter une deuxième partie de courant de test traversant la deuxième ligne d'alimentation (8b) sont couplés,
**caractérisé en ce que**
le premier transformateur de courant de mesure (44a) et le deuxième transformateur de courant de mesure (44b) sont configurés comme transformateurs de courant de mesure sensibles à tous courants ayant une sortie de courant et sont couplés en parallèle du côté secondaire pour la compensation indirecte de parties de courant différentiel (Idiff,a, Idiff,b).

5. Système de localisation de défauts d'isolement (50) pour un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le système de localisation de défauts d'isolement (50) comprenant un générateur de courant de test (12) pour injecter un courant de test et un dispositif de localisation de défauts d'isolement (18), auquel un premier transformateur de courant de mesure (54a) pour détecter une première partie de courant de test traversant la première ligne d'alimentation (8a) et un deuxième transformateur de courant de mesure (54b) pour détecter une deuxième partie de courant de test traversant la deuxième ligne d'alimentation (8b) sont couplés,
**caractérisé en ce que**
le premier transformateur de courant de mesure (54a) et le deuxième transformateur de courant de mesure (54b) sont configurés comme transformateurs de courant de mesure sensibles à tous courants ayant une sortie de tension et sont couplés en série du côté secondaire pour la compensation indirecte de parties de courant différentiel (Idiff,a, Idiff,b).

6. Système de localisation de défauts d'isolement (60) pour un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le système de localisation de défauts d'isolement (60) comprenant un générateur de courant de test (12) pour injecter un courant de test et un dispositif de localisation de défauts d'isolement (68), auquel un premier transformateur de courant de mesure (64a) pour détecter une première partie de courant de test traversant la première ligne d'alimentation (8a) et un deuxième transformateur de courant de mesure (64b) pour détecter une deuxième partie de courant de test traversant la deuxième ligne d'alimentation (8b) sont couplés,
**caractérisé en ce que**
le premier transformateur de courant de mesure (64a) et le deuxième transformateur de courant de mesure (64b) sont configurés comme transformateurs de courant de mesure sensibles à tous courants et le dispositif de localisation de défauts d'isolement (68) comprend une unité d'évaluation (62) qui est configurée pour compenser indirectement des parties de courant différentiel (Idiff,a, Idiff,b) par voie de calcul.

7. Système de localisation de défauts d'isolement selon l'une quelconque des revendications 4 à 6,
**caractérisé en ce que**
le chemin résistif selon la revendication 1 ou le chemin de courant ayant un dispositif de réglage de courant selon la revendication 2 ou 3 est installé comme dispositif de compensation complémentaire.

8. Procédé de localisation de défauts d'isolement dans un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le procédé comprenant les étapes consistant à :
- augmenter une tension d'alimentation de la première source de tension continue (4a) ou de la deuxième source de tension continue (4b) en utilisant un dispositif de réglage (19),
- injecter un courant de test en utilisant un générateur de courant de test (12),
- détecter une première partie de courant de test traversant la première ligne d'alimentation (8a) en utilisant un premier transformateur de courant de mesure (14a) couplé à un dispositif de localisation de défauts d'isolement (18), et détecter une deuxième partie de courant de test traversant la deuxième ligne d'alimentation (8b) en utilisant un deuxième transformateur de courant de mesure (14b) couplé au dispositif de localisation de défauts d'isolement (18),
**caractérisé par** les étapes consistant à
- générer un premier courant de compensation (Idccomp,a) entraîné par les sources de tension continue (4a, 4b) dans un premier chemin résistif (22a) entre les conducteurs actifs (10) de la première ligne d'alimentation (8a), et générer un deuxième courant de compensation (Idccomp,b) entraîné par les sources de tension continue (4a, 4b) dans un deuxième chemin résistif (22b) entre les conducteurs actifs (10) de la deuxième ligne d'alimentation (8b), le courant de compensation (Idccomp,a, Idccomp,b) respectif étant égal à un courant continu différentiel (Idcdiff,a, Idcdiffb) parasite dans la ligne d'alimentation (8a, 8b) respective provoqué par l'augmentation de la tension d'alimentation et étant détecté du côté primaire dans la direction opposée du courant continu différentiel (Idcdiff,a, Idcdiff,b) par le transformateur de courant de mesure (14a, 14b) respectif.

9. Procédé de localisation de défauts d'isolement dans un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le procédé comprenant les étapes consistant à :
- augmenter une tension d'alimentation de la première source de tension continue (4a) ou de la deuxième source de tension continue (4b) en utilisant un dispositif de réglage (19),
- injecter un courant de test en utilisant un générateur de courant de test (12),
- détecter une première partie de courant de test traversant la première ligne d'alimentation (8a) en utilisant un premier transformateur de courant de mesure (14a) couplé à un dispositif de localisation de défauts d'isolement (18), et détecter une deuxième partie de courant de test traversant la deuxième ligne d'alimentation (8b) en utilisant un deuxième transformateur de courant de mesure (14b) couplé au dispositif de localisation de défauts d'isolement (18),
**caractérisé par** l'étape consistant à
- générer et régler un courant de compensation (Idccomp,a, Idccomp,b) dépendant d'un courant de charge dans un chemin de courant (32a, 32b) entre les conducteurs actifs (10) de la première ligne d'alimentation (8a) et entre les conducteurs actifs (10) de la deuxième ligne d'alimentation (8b) en utilisant un dispositif de réglage de courant (34a, 34b), le courant de compensation (Idccomp,a, Idccomp,b) respectif étant égal à un courant continu différentiel (Idcdiff,a, Idcdiff,b) parasite dans la ligne d'alimentation (8a, 8b) respective provoqué par l'augmentation de la tension d'alimentation et étant détecté du côté primaire dans la direction opposée du courant continu différentiel (Idcdiff,a, Idcdiff,b) par le transformateur de courant de mesure (14a, 14b) respectif.

10. Procédé de localisation de défauts d'isolement selon la revendication 9,
**caractérisé en ce que**
le courant de compensation dépendant d'un courant de charge est généré et réglé en utilisant une source de courant réglable et un courant continu de charge est mesuré en utilisant un capteur de courant.

11. Procédé de localisation de défauts d'isolement dans un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le procédé comprenant les étapes consistant à :
- injecter un courant de test en utilisant un générateur de courant de test (12),
- détecter une première partie de courant de test traversant la première ligne d'alimentation (8a) en utilisant un premier transformateur de courant de mesure (44a) couplé à un dispositif de localisation de défauts d'isolement (18), et détecter une deuxième partie de courant de test traversant la deuxième ligne d'alimentation (8b) en utilisant un deuxième transformateur de courant de mesure (44b) couplé au dispositif de localisation de défauts d'isolement (18),
**caractérisé par** l'étape consistant à
- coupler le premier transformateur de courant de mesure (44a) et le deuxième transformateur de courant de mesure (44b), qui sont configurés comme transformateurs de courant de mesure sensibles à tous courants ayant une sortie de courant, en parallèle du côté secondaire pour la compensation indirecte de parties de courant différentiel (Idiff,a, Idiff,b).

12. Procédé de localisation de défauts d'isolement dans un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le procédé comprenant les étapes consistant à :
- injecter un courant de test en utilisant un générateur de courant de test (12)
- détecter une première partie de courant de test traversant la première ligne d'alimentation (8a) en utilisant un premier transformateur de courant de mesure (54a) couplé à un dispositif de localisation de défauts d'isolement (18), et détecter une deuxième partie de courant de test traversant la deuxième ligne d'alimentation (8b) en utilisant un deuxième transformateur de courant de mesure (54b) couplé au dispositif de localisation de défauts d'isolement (18),
**caractérisé par** l'étape consistant à
- coupler le premier transformateur de courant de mesure (54a) et le deuxième transformateur de courant de mesure (54b), qui sont configurés comme transformateurs de courant de mesure sensibles à tous courants ayant une sortie de tension, en série du côté secondaire pour la compensation indirecte de parties de courant différentiel (Idiff,a, Idiff,b).

13. Procédé de localisation de défauts d'isolement dans un système d'alimentation en courant continu (2) non mis à la terre, qui est alimenté de manière redondante par une première source de tension continue (4a) connectée en diode et une deuxième source de tension continue (4b) connectée en diode et auquel un consommateur (6) est couplé de façon redondante par une première ligne d'alimentation (8a) se composant de deux conducteurs actifs (10) et une deuxième ligne d'alimentation (8b) se composant de deux conducteurs actifs (10), le procédé comprenant les étapes consistant à :
- injecter un courant de test en utilisant un générateur de courant de test (12),
- détecter une première partie de courant de test traversant la première ligne d'alimentation (8a) en utilisant un premier transformateur de courant de mesure (64a) couplé à un dispositif de localisation de défauts d'isolement (68), et détecter une deuxième partie de courant de test traversant la deuxième ligne d'alimentation (8b) en utilisant un deuxième transformateur de courant de mesure (64b) couplé au dispositif de localisation de défauts d'isolement (68),
**caractérisé par** l'étape consistant à
- évaluer les signaux de mesure fournis par les transformateurs de courant de mesure (64a, 64b) sensibles à tous courants en compensant indirectement des parties de courant différentiel (Idiff,a, Idiff,b) par voie de calcul.

14. Procédé de localisation de défauts d'isolement selon l'une quelconque des revendications 11 à 13,
**caractérisé en ce que**
comme étapes complémentaires pour compenser le courant continue différentiel parasite, un courant de compensation entraîné par les sources de tension continue est généré dans un chemin résistif selon la revendication 8 ou un courant de compensation dépendant d'un courant de charge est généré et réglé dans un chemin de courant selon la revendication 9 ou 10.
